Europäisches Patentamt

(19) European Patent Office

Office européen des brevets

(11) Publication number : **0 462 743 A1**

## (12) EUROPEAN PATENT APPLICATION

(21) Application number : **91305259.3**

(51) Int. Cl.⁵ : **G01R 31/28**

(22) Date of filing : **11.06.91**

(30) Priority : **20.06.90 US 541223**

(43) Date of publication of application :
**27.12.91 Bulletin 91/52**

(84) Designated Contracting States :
**DE FR GB IT NL**

(71) Applicant : **AMERICAN TELEPHONE AND
TELEGRAPH COMPANY
550 Madison Avenue
New York, NY 10022 (US)**

(72) Inventor : **Zorian, Yervant
31B Chicopee Drive
Princeton, New Jersey 08540 (US)**

(74) Representative : **Johnston, Kenneth Graham et
al
AT&T (UK) LTD. AT&T Intellectual Property
Division 5 Mornington Road
Woodford Green Essex, IG8 OTU (GB)**

(54) **Method and apparatus for accomplishing output-specific data compaction.**

(57)   Compaction of the bits in each row of an $m \times n$ array into a bit indicative of the presence of one or more predetermined bit patterns in any of the rows is accomplished by first processing the bits in each row to obtain an output bit indicative of the presence of the predetermined bit patterns in the row. These output bits are logically combined over time to yield a single bit indicative of the presence of the predetermined bit patterns in any of the array rows.

EP 0 462 743 A1

# FIG. 1

## Technical Field

This invention relates generally to a technique for compacting (reducing) the data read out from an array to yield a reduced volume of data without any loss of information.

## Background of the Invention

There is currently a trend in the electronics industry towards fabricating Very Large Scale Integrated (VLSI) circuits which contain many different functional blocks or elements. As such VLSI circuits become more complex, the interest in providing such circuits with the capability of testing themselves (built-in self-test) has become more intense. To date, there is no known single Built-In Self-Test (BIST) technique which can efficiently test each of the various different types of functional elements that may exist within a VLSI circuit. Rather, a "divide and conquer" approach is typically adopted, and separate BIST techniques, each specific to a particular element within the circuit, such as a memory array, are typically employed.

The most common BIST technique employed to test an $m$ row by $n$ column memory array is the "marching" algorithm. The marching algorithm is carried out by performing a deterministic set of read and write operations. Each write operation generally consists of writing either all "0's" or all "1's" into the array. When all "1's" have been written into the array, the contents of each successive row are read during a subsequent read operation to see if any "0's" are present. Conversely, the array, when all "0's" are written in the array, each successive row, is read to detect the presence of a "1." The presence of a "1" or "0" when the array has been written with all "0's" and all "1's," respectively, is indicative of a memory fault.

To successfully execute the marching algorithm on an $m \times n$ memory array, an analysis of the data read from each successive row is required to detect the presence of a "1" or "0" in the row. One possible approach is to employ a set of $n$ exclusive OR gates, each serving to compare the contents of an individual one of the $n$ columns in each successive row to a "1" or "0" as required. This approach suffers the disadvantage that a significant area overhead cost is incurred. In other words, a large amount of area within the VLSI circuit must be devoted to the hardware necessary to accomplish such comparison. Generally speaking, it is desirable to minimize the area required for BIST-associated hardware.

The conventional alternative to exclusive OR gates is to compact or reduce the data read out by the use of a Multiple Input Shift Register (MISR) for this purpose. The MISR serves to reduce (i.e., compact) the bits in each successive row read from the array into a single bit by performing a polynomial division on the row of bits read from the array. Thus, the MISR effectively compacts the $m \times n$ rows of bits into a single string (signature) of $n$ bits. While the MISR effectively reduces the amount of data, the remaining $n$ bit signature of the MISR does not accurately reflect the existence of all the possible faults in the array. In other words, during the compaction of the data by the MISR, some information is lost.

To understand this loss of information, consider the fact that for an $n \times m$ array there will only be one which is fault-free but $2^{n \times m} - 1$ possible faulty arrays. The $n$ bit signature of the MISR will reveal the presence of $n$ possible fault-free arrays. However, there will be as many as $2^{n \times m - n} - 1$ sets of faulty arrays which may not be revealed by the MISR signature.

Thus, there is need for a technique which accomplishes compaction without losing any information.

## Summary of the Invention

Briefly, in accordance with a preferred embodiment of the invention, a technique is disclosed for compacting the bits of an $m$ row by $n$ bit array into a single bit whose state is indicative of whether at least one predetermined pattern of bits is present in each of the rows of the array. The method is practiced by reading out successive rows of bits from the array and then processing each row to obtain a single bit whose state is indicative of whether at least one predetermined pattern of bits is present in the row just read. The output bit obtained is then logically combined with the output bit associated with the preceding row read from the array. The steps of reading and processing successive ones of the $m$ rows of bits and logically combining the output bits associated with each of the rows are repeated until all of the $m$ rows of bits in the array are read and processed and their output bits are combined into a single bit. The state of the output bit which results at the completion of these steps will thus be indicative of whether at least one predetermined pattern of bits is present in each of the $m$ rows in the array. This technique affords the advantage of compacting the $m \times n$ bits in the array into a single bit with no loss of information.

## Brief Description of the Drawing

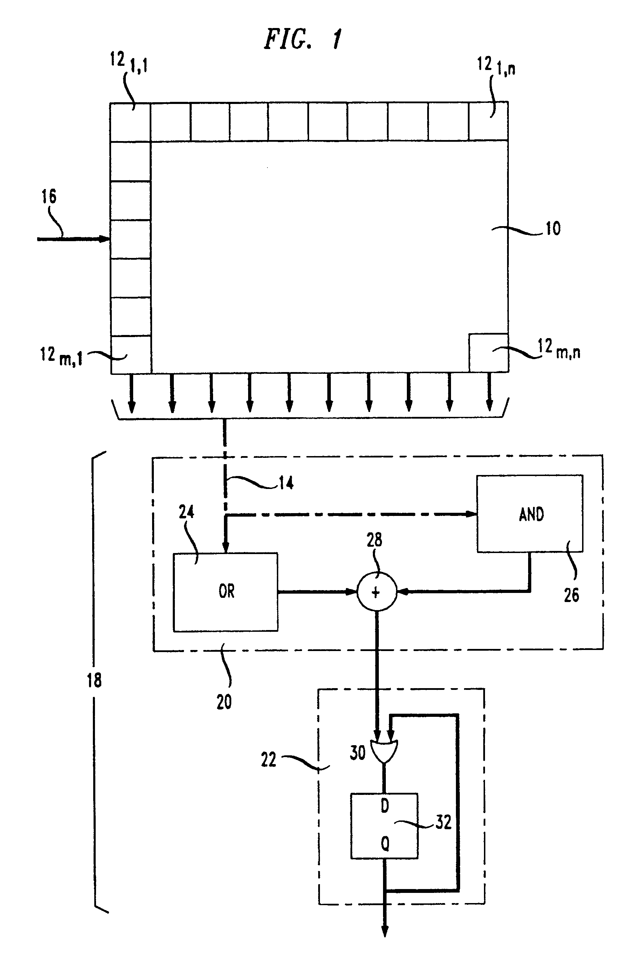

FIG. 1 is a block schematic diagram of an apparatus, in accordance with the present invention, for compacting the bits of an $m \times n$ array.

## Detailed Description

FIG. 1 shows a memory array 10 comprised of $m$ rows by $n$ columns of memory cells 12 (where $m$ and $n$ are integers), each cell storing an individual bit of data. Associated with the memory array is a data bus 14 and an address bus 16. Data is written into, or read from, a particular one of the $m$ rows of cells 12 via the data bus 14 by first placing the address of the row on the data bus 16.

Testing of the array 10 is typically carried out by performing a set of deterministic read and write operations. Each write operation is carried out by writing the cells 12 in the array 10 with all "1's" or all "0's." Each read operation is carried out by reading each successive row of cells 12 to detect a "0" when all "1's" have been written into the array 10 and, conversely, to detect a "1" when all "0's" have been written. When performing testing of the memory array 10 in this fashion, it is desirable to compact (i.e. reduce) the bits read from the array to simplify the testing. In the past, a multiple input shift register (MISR) (not shown) has been employed for this purpose to compact the $m \times n$ bits into an $n$ bit signature. As indicated, the disadvantage of this approach is that there is a loss of information in that the $n$ bit MISR signature may not reveal the existence of as many as $2^{m \times n} - n - 1$ faulty arrays.

In accordance with the invention the $m \times n$ bits read from the array 10 can advantageously be compacted into a single bit by a compaction apparatus 18 with no loss of information. The compaction apparatus 18 of the invention comprises a pair of logic circuits 20 and 22. The logic circuit 20 serves to compact the bits output on the data bus 14 into a single output bit whose state indicates whether at least one particular pattern of bits is present in each successive row of cells 12 read from the array 10. The logic circuit 22 serves to compact (i.e. reduce) the bits successively output by the logic circuit 20 over time to yield a single bit whose state is indicative of whether each of the $m$ rows of cells contains one or more predetermined bit patterns.

When testing the memory array 10 in the manner described above, the bit patterns of all "1's" and all "0's" indicates a fault-free state when all "1's and "0's," respectively, have been written into the array. Thus, in the illustrated embodiment, the logic circuits 20 and 22 have been configured so that the state of the resultant bit produced by the compaction apparatus 18 is indicative of whether a pattern of all "1's" or all "0's" is present. To this end, the logic gate 20 is comprised of the combinarion of an $n$ bit OR gate 24 and an $n$ bit AND gate 26, each gate having a separate one of its $n$ inputs coupled to the data bus 14 to receive the bit stored in a separate one of the $n$ cells of the row of cells being read.

The OR gate 24 operates to logically OR the bits on the bus 14 and produce an output bit whose state varies accordingly. Thus, the output bit by the OR gate 24 will be "0" only when all of the bits on the bus 14 are each a "0." Otherwise, if any of the bits on the bus 14 are a " 1," then the OR gate 24 will output a "1 " bit. The AND gate 26 serves to logically AND the bits on the bus 14 and produce an output bit whose state varies accordingly. Only when all of the bits on the bus 14 are a "1" will the AND gate 26 output a "1" bit.

Otherwise, the AND 26 gate will output a "0".

The bits output by the OR and AND gates 24 and 26, respectively, are logically combined by an exclusive OR (XOR) gate 28 whose output is the output of the logic circuit 20. The XOR gate 28 output bit (and by implication, the output bit of the logic gate 20) will be at a "0" level when the output bits of the OR and AND gates 24 and 26, respectively, are both a "0" or are both a " 1." For any other combination of bits input to the XOR gate 28 from the OR and AND gates 24 and 26, the output bit of the XOR gate (and hence the logic circuit 20) will be a "1."

As may now be appreciated, only when a string of all "0's" or all "1's" is present on the bus 14 will the output bit of the logic circuit 20 be "0." Any other combination of "0's" and "1's" on the bus 14 will cause the output bit of the logic circuit 20 to be "1." Thus, the state of a single bit output by the logic circuit 20 indicates whether a bit pattern of all "0's" or all "1's" is present on the bus 14. By providing a single output bit indicative of whether either of these two bit patterns is present on the data bus 14, the logic circuit 20 advantageously compacts (i.e., reduces) the $n$ bits on the data bus to a single bit. The compaction of the length of the bits in the bus 14 to a single bit is known as "space" compaction.

While the logic circuit 20 advantageously compacts the $n$ bits on the bus 14 into a single bit, the logic circuit will produce, over time, a stream of $m$ bits, one for each of the $m$ rows read from the array 10. It is the function of the logic circuit 22 to compact the bits received from the logic circuit 20 to produce a single bit which is indicative of whether a bit pattern of all "0's" or all "1's" appears on the bus 14 for each successive one of the $m$ rows of the array 10. To this end, the logic circuit 22 comprises the combination of a two-input OR gate 30 and a flip-flop 32. The OR gate 30 has its first input coupled to the output of the logic circuit 20 (i.e., the output of the XOR gate 28). The output of the OR gate 30 is coupled to the input of the flip-flop 32 whose output is fed back to the second input of the OR gate. The output of the flip-flop 32 functions as the output for the logic circuit 22.

In operation, the logic circuit 20, over time, supplies the first input of the OR gate 30 (i.e., the input of the logic circuit 22) with successive bits, each bit indicating the presence of all "0's" or all "1's" in each successive row of cells 12 read from the array 10. Initially, the output of the flip-flop 32 is presumed to be a "0," so if a bit at a "1" logic level appears at the input of the flip-flip 32, the flip-flop becomes set and will generate a "1" at its output. Since the output bit of the flip-flop 32 is fed back to the second input of the OR gate 30, the flip-flop will be continuously set by the presence of a previous "1" bit regardless of the state of each subsequent bit received from the logic circuit 20.

As can now be appreciated, so long as each successive bit output by the logic gate 20 is a "0," then the bit output by the logic gate 22 will be a "0." Thus, if every one of the successive rows of cells 12 read from the array 10 has a bit pattern of all "0's" or all "1's," then the state of the bit output by the logic gate 22 after the last row of cells has been read will be a "0. " Should any of the rows of cells 12 of the array 10 contain a bit pattern other than all "0's" or all "1's," the bit output by the logic gate 22 after the last row of cells 12 is read will be a "1." In this way, the state of the bit output by the logic gate 22 after the last row of cells 12 is read is indicative of whether each of the rows contain all "0's" or all "1's".

In the illustrated embodiment, the logic circuit 20 is configured to compact the bits in each row of cells 12 to yield a single bit indicative of whether each successive row contains all "0's" or all "1's. " Thus, the compaction provided by the logic circuit 20 is dependent on whether a predetermined bit pattern (e.g., all "0's" or all "1's") is present on the bus 14. In other words, the compaction provided by the logic circuit 20 is output specific. To compact the bits in each row of cells 12 in accordance with another predetermined bit pattern, then the logic circuit 20 must be configured differently to generate a "0" bit when such a predetermined bit pattern is present in each of the rows of cells 12 read from the array 10. Even if the configuration of the logic circuit 20 is changed, in order to accomplish "space compaction" of a different predetermined bit pattern, the configuration of the logic circuit 22 will remain the same.

The foregoing describes a technique for compacting the bits contained in an $m$ x $n$ array into a single bit indicate of whether at least one predetermined pattern of bits is present in the rows in the array.

It is to be understood that the above-described embodiments are merely illustrative of the principles of the invention. Various modifications and changes may be made thereto by those skilled in the art which will embody the principles of the invention and fall within the spirit and scope thereof.

## Claims

1. A method for compacting the bits of an $m$ row by $n$ column array ( 10) into a single bit whose state is indicative of whether at least one predetermined pattern of bits is present in each of the $m$ rows of the array, the method CHARACTERIZED BY the steps of:

   (a) reading and processing the bits in a successive one of the rows of an $m$ row by $n$ column array (10) and generating an output bit whose state is indicative of whether at least one predetermined pattern of bits is present in the row.

   (b) logically combining the output bit with the output bit associated with the preceding successive row read from the array; and

   (c) repeating the steps of (a) and (b) in succession until all of the $m$ rows of bits in the $m$ x $n$ array have been read and processed, whereupon the state of the resultant output bit is indicative of whether at least one predetermined bit pattern is present in any of the $m$ rows of the array.

2. The method according to claim 1 CHARACTERIZED IN THAT the bits read from each successive row of the array are processed to generate an output bit indicative of whether the bits read from the row are either all "0's" or all "1's."

3. The method according to claim 2 CHARACTERIZED IN THAT the bits are processed by simultaneously AND'ing and OR'ing the bits read from each successive row of the array so as to generate each of a pair of intermediate bits whose state is indictive of whether a pattern of all "0's" or all "1's," respectively, is present in the row just read and then exclusively OR'ing the two intermediate bits.

4. The method according to claim 1 CHARACTERIZED IN THAT the output bits are logically combined by the steps of:

   (a) temporarily storing the initial one of the successive output bits;
   (b) logically OR'ing the temporarily stored bit with the next successive output bit to produce a resultant bit;
   (c) temporarily storing the resultant bit in place of the initial one of the successive bits; and
   (d) repeating the steps of (b) and (c) until the last of the successive output bits has been OR's with the temporarily stored bit.

5. Apparatus for compacting the bits stored in an $m$ by $n$ column array into a single bit whose state is indicative of whether at least one predetermined pattern of bits is present in each row of the array, CHARACTERIZED BY:

   first means (20) for reading and processing each of the bits stored in a successive row of an $m$ x $n$ array to generate an output bit whose state is indicative of whether the row contains at least one predetermined pattern of bits; and
   second means (22) for logically combining the output bits successively generated by the first means to yield a single bit whose state is indicative of whether at least one predetermined pattern of bits is present in any of the rows of the array.

6. The apparatus according to claim 5 CHARACTERIZED IN THAT the first means generates an output bit for each successive row read from the array to indicate whether the row contains a bit pattern of either all "0's" or all "1's. "

7. The apparatus according to claim 6 CHARACTERIZED IN THAT the first means comprises:

an *n* bit OR gate (24) for OR'ing the bits in each successively read row of the array;

an *n* bit AND gate (26) for AND'ing the bits in each successively read row of the array; and

an exclusive OR (XOR) gate (28) for exclusively OR'ing the bits produced by the AND and OR gates to generate an output indicative of whether the bits in each successively read row of the array are all "0's" or all "1's."

8. The apparatus according to claim 5 CHARACTERIZED IN THAT the second means comprises:

a two-input OR gate (30) having a first input supplied with the output bit generated by the first means; and

a flip-flop (32) supplied at its input with the output of the two-input OR gate and having its output fed to the second of the inputs of the OR gate.

## FIG. 1

European Patent
Office

**EUROPEAN SEARCH REPORT**

Application Number

| | DOCUMENTS CONSIDERED TO BE RELEVANT | | EP 91305259.3 |
|---|---|---|---|
| **Category** | **Citation of document with indication, where appropriate, of relevant passages** | **Relevant to claim** | **CLASSIFICATION OF THE APPLICATION (Int. Cl.5)** |
| X | <u>DE - A1 - 3 930 165</u> (AKADEMIE DER WISSENSCHAFTEN DER DDR) * Abstract * | 1,5 | G 01 R 31/28 |
| A | | 2-4, 6-8 | |
| A | <u>EP - A1 - 0 131 349</u> (HEWLETT-PACKARD) * Abstract * | 1-8 | |
| | | | **TECHNICAL FIELDS SEARCHED (Int. Cl.5)** |
| | | | G 01 R 31/00 H 01 L 21/00 H 05 K 13/00 |

The present search report has been drawn up for all claims

| Place of search | Date of completion of the search | Examiner |
|---|---|---|
| VIENNA | 30-09-1991 | KUNZE |

EPO FORM 1503 03.82 (P0401)